# FASCICULE DE BREVET EUROPEEN

(11) **EP 0 782 229 B1**
(45) Date de publication et mention de la délivrance du brevet: **10.03.1999**
(21) Numéro de dépôt: 96402875.7
(22) Date de dépôt: 24.12.1996
(51) Int. Cl.: H01S 3/085

(54) **Laser semi-conducteur à émission par la surface**
Oberflächen-emittierender Halbleiterlaser
Semiconductor surface emitting laser

(30) Priorité: 27.12.1995 FR 9515543
(43) Date de publication de la demande: 02.07.1997
(73) Titulaire: ALCATEL, 75008 Paris (FR)
(72) Inventeur: Salet, Paul, 92140 Clamart (FR)
(74) Mandataire: Fournier, Michel Robert Marie

(56) Documents cités:
- US-A- 5 245 622
- IEICE TRANSACTIONS ON ELECTRONICS, vol. E78-C, no. 9, 1 Septembre 1995, pages 1311-1314, XP000545795 SEIIJI UCHIYAMA ET AL: "GAINASP/INP SQUARE BURIED-HETEROSTRUCTURE SURFACE-EMITTING LASERS REGROWN BY MOCVD"
- ELECTRONICS LETTERS, vol. 31, no. 23, 9 Novembre 1995, page 2014/2015 XP000546736 LI G S ET AL: "POLARISATION AND MODAL BEHAVIOUR OF LOW THRESHOLD OXIDE AND AIRGAP CONFINED VERTICAL CAVITY LASERS"
- COMPOUND SEMICONDUCTORS 1994, SAN DIEGO, SEPT. 18 - 22, 1994, no. PROC. 21, 18 Septembre 1994, GORONKIN H;UMESH MISHRA (EDS ), pages 563-566, XP000509710 ROCHUS S ET AL: "VERTICAL-CAVITY SURFACE-EMITTING LASERS WITH BURIED LATERAL CURRENT CONFINEMENT"
- ELECTRONICS LETTERS, vol. 31, no. 11, 25 Mai 1995, pages 886-888, XP000519105 YANG G M ET AL: "ULTRALOW THRESHOLD CURRENT VERTICAL-CAVITY SURFACE-EMITTING LASERS OBTAINED WITH SELECTIVE OXIDATION"
- JAPANESE JOURNAL OF APPLIED PHYSICS, vol. 33, no. 4A, PART 01, 1 Avril 1994, pages 1905-1909, XP000487633 TOSHIHIKO BABA ET AL: "CONTINUOUS WAVE GAINASP/INP SURFACE EMITTING LASERS WITH A THERMALLY CONDUCTIVE MGO/SI MIRROR"

## Description

L'invention a trait à une catégorie particulière de lasers semi-conducteurs appelés "lasers à émission par la surface" ou VCSEL (de l'anglais : "Vertical Cavity Surface Emitting Laser").

Ces lasers sont réalisés à partir d'un substrat composé d'un alliage semi-conducteur de type III-V tel que l'arséniure de gallium GaAs ou le phosphure d'indium InP.

Contrairement aux lasers semi-conducteurs classiques, l'émission de lumière s'effectue perpendiculairement à la surface de la couche active et dans la même direction que l'injection du courant électrique entretenant l'effet laser. Ainsi, dans le cas d'un substrat InP, le composant est essentiellement constitué d'une cavité résonnante délimitée par deux miroirs diélectriques ou semi-conducteurs opposés. La cavité résonnante est formée d'une couche InP dopée p, d'une couche active quaternaire GaInAsP et d'une couche InP dopée n. L'injection de courant s'effectue par intermédiaire de deux électrodes disposées de part et d'autre de la cavité résonante. L'une au moins de ces électrodes est nécessairement placée à côté ou plus généralement autour du miroir qui est situé sur la même face. Le bon fonctionnement d'une telle structure est conditionné par un confinement suffisant de la couche active aussi bien du point de vue optique qu'électrique. Pour cela, on choisit généralement une structure où la couche active est enterrée dans un milieu possédant un plus faible indice de réfraction. Si la couche active bonne conductrice est de plus enterrée dans un milieu dopé p à la frontière du milieu n, on obtiendra également un confinement électrique dû à la tension de seuil de la jonction p-n qui entoure la couche active.

Pour réaliser des lasers à forte puissance et à émission continue, il est nécessaire de renforcer le confinement électrique afin d'améliorer le rendement et de diminuer l'échauffement du composant. Une solution à ce problème a été proposée dans l'article : "Continnous Wave GaInAsP/InP Surface Emitting Lasers with a Thermally Conductive MgO/Si Mirror", Toshihiko BABA et al, Japanese Journal of Applied Physics, Vol.33 (1994), pages 1905-1909, Part 1, N°4A, April 1994.

Dans cet article, il est proposé de placer une jonction bloquante s'appuyant tout autour de la couche active enterrée.

Cette solution permet bien d'améliorer le confinement électrique. Toutefois le rendement n'est pas optimale. En effet, les mesures et les simulations sur une telle structure montrent que la densité du courant à travers la couche active n'est pas uniforme. Plus précisément, la densité du courant est plus élevée (dans un rapport de l'ordre de 4) à la périphérie de la couche active qu'à son centre. Il en résulte que l'effet laser ne peut être obtenu que sur un mode annulaire car la densité de porteurs au centre est inférieure à celle requise pour atteindre le seuil laser.

Aussi l'invention a pour but de proposer une structure de laser à émission par la surface présentant un rendement amélioré et par conséquent un échauffement inférieur et donc un courant de seuil réduit.

Dans ce but, l'invention a pour objet un laser à émission par la surface du type comportant une couche active enterrée dans une couche d'injection de courant électrique composée d'un alliage semi-conducteur III-V dopé p, au moins un miroir parallèle à la couche active et disposé sur la couche d'injection, une électrode placée à côté dudit miroir et en contact électrique avec la couche d'injection, caractérisé en ce qu'il comporte une couche de blocage de courant située dans la couche d'injection selon un plan sensiblement parallèle à la couche active, ladite couche de blocage étant munie d'une ouverture centrée par rapport à la couche active et de dimensions inférieures à celle-ci.

Le fait de prévoir une ouverture dans la couche de blocage plus petite que la couche active a pour effet de compenser le caractère excentré de l'injection de courant dû à la position de l'électrode qui ne doit pas recouvrir le miroir. La position et l'épaisseur de la couche de blocage, la position et les dimensions de l'ouverture pourront être optimisées par simulations de façon à obtenir une densité de courant la plus uniforme possible au niveau de la couche active.

Aussi, selon un aspect supplémentaire de l'invention, les dimensions de l'ouverture et la distance entre la couche de blocage et la couche active sont choisies pour que le courant électrique traversant la couche active présente une densité de courant uniforme. En effet, ces deux paramètres sont déterminants pour ajuster la répartition du potentiel électrique dans la structure et donc obtenir l'uniformisation de la densité du courant.

D'autres aspects de réalisation de l'invention apparaîtront dans la suite de la description en référence aux figures.
- les figures 1 à 5 illustrent les principales étapes de fabrication du laser selon l'invention;
- la figure 6 est une vue en coupe du laser selon l'invention.

Les étapes de fabrication du laser selon l'invention sont données dans le cas particulier d'un substrat InP. Cependant le procédé pourrait être appliqué à tout autre substrat composé d'un alliage III-V tel que GaAs.

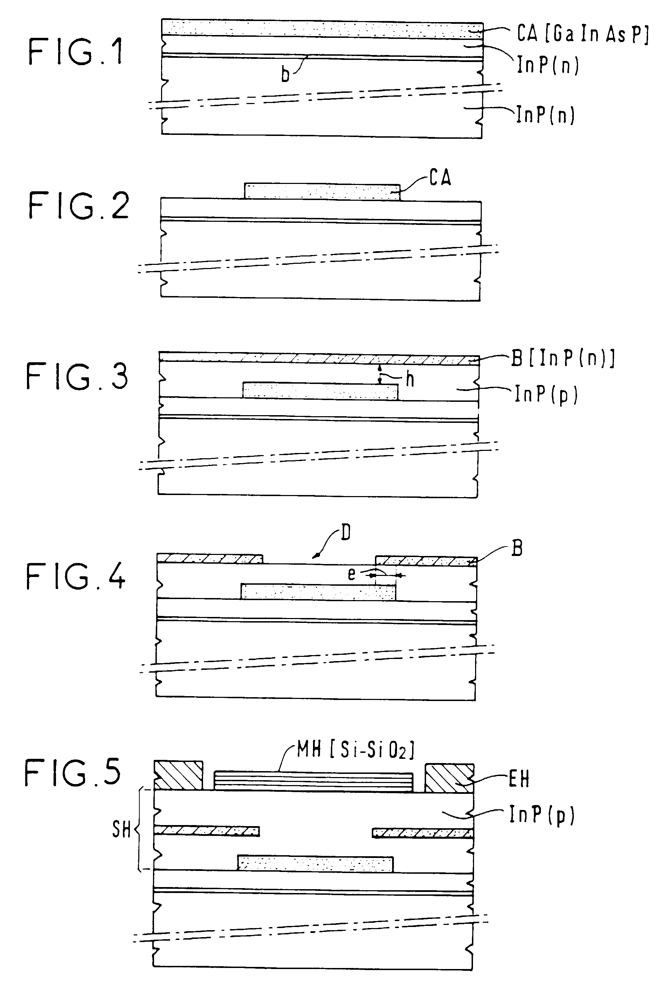

Comme représenté à la figure 1, le procédé débute par une étape de croissance InP dopé n sur un substrat de même composition. On forme ensuite une couche quaternaire d'arrêt de gravure b. On poursuit par une croissance InP dopé n sur une épaisseur définissant la distance entre la couche active et le miroir inférieur du composant. On forme alors une couche active quaternaire CA sur toute la surface du cristal.

Une gravure de la couche CA sert ensuite à former un mésa de couche active tel que représenté à la figure 2.

Comme le montre la figure 3, une croissance InP dopé p permet d'enterrer la couche active CA. Puis, une croissance InP dopée n permet de réaliser une couche de blocage B sur toute la surface du cristal. La distance h entre la couche active et la couche de blocage est ajustée précisément. Cette distance h peut être obtenue par des calculs de simulation visant à obtenir une densité de courant uniforme dans la couche active.

Une ouverture D centrée sur la couche active est alors formée par gravure de la couche de blocage B(figure 4). Les dimensions de l'ouverture D sont inférieures à celles de la couche active de façon à présenter un surplomb e dont la valeur précise sera également donnée par la simulation.

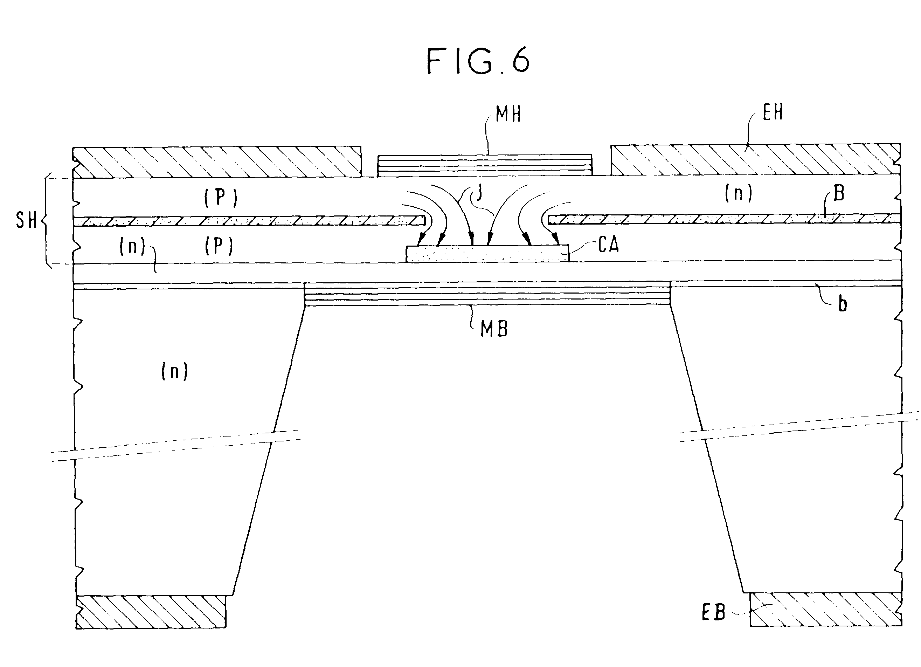

Selon la figure 5, on effectue ensuite une nouvelle croissance InP dopée p, ce qui termine la formation de la couche d'injection de courant SH. On place ensuite le miroir diélectrique supérieur MH constitué de couches alternées Si-SiO₂. On place enfin l'électrode supérieure EH autour du miroir MH.

Pour obtenir le composant terminé représenté à la figure 6, on effectue une gravure de la partie inférieure du substrat InP jusqu'à la couche d'arrêt b, on forme le miroir inférieur MB et on place l'électrode inférieure EB.

Au lieu de réaliser la couche de blocage B par croissance InP dopé n, on pourrait utiliser un isolant électrique tel qu'un oxyde d'aluminium. Selon une autre variante, on pourrait réaliser la couche de blocage B par gravure latérale de la couche d'injection SH. Il convient toutefois de noter que la croissance InP dopé n présente l'avantage de la simplicité et d'éviter des problèmes de reprise d'épitaxie dans le cas où la couche d'oxyde serait en désaccord de maille avec le milieu InP dopé p.

Il faut d'autre part signaler que les dessins ne sont que des représentations schématiques. En effet, toutes les couches représentées comme planes ne le sont pas nécessairement en réalité.

En particulier, la couche de blocage B présentera en pratique une déformation vers le haut qui est due à la reprise d'épitaxie sur le mesa visible sur la figure 2.

Quelques données de dimensionnement sont enfin données à titre d'illustration :
- diamètre de la couche active CA : 8 µm
- épaisseur de la couche active CA : 0,7 µm
- distance h entre couches active CA et de blocage B:1 µm
- valeur de surplomb e : 1 µm.
- épaisseur de la couche d'injection SH : 4 µm
- diamètre des miroirs MH et MB : 10 à 16 µm.

## Revendications

1. Laser à émission par la surface du type comportant une couche active (CA) enterrée dans une couche d'injection de courant électrique (SH) composée d'un alliage semi-conducteur III-V dopé p, au moins un miroir (MH) parallèle à la couche active (CA) et disposé sur la couche d'injection (SH), une électrode (EH) placée à côté dudit miroir (MH) et en contact électrique avec la couche d'injection (SH), caractérisé en ce qu'il comporte une couche de blocage (B) de courant située dans la couche d'injection (SH) selon un plan sensiblement parallèle à la couche active (CA), ladite couche de blocage (B) étant munie d'une ouverture (D) centrée par rapport à la couche active (CA) et de dimensions inférieures à celle-ci.

2. Laser selon la revendication 1, caractérisé en ce que les dimensions de l'ouverture (D) et la distance (h) entre la couche de blocage (B) et la couche active (CA) sont choisies pour que le courant électrique traversant la couche active (CA) présente une densité de courant (J) uniforme.

3. Laser selon l'une des revendications 1 ou 2, caractérisé en ce que ladite couche de blocage (B) est composée dudit alliage semi-conducteur III-V dopé n.

4. Laser selon l'une des revendications 1 ou 2, caractérisé en ce que ladite couche de blocage est constituée d'un isolant électrique.

5. Laser selon la revendication 4, caractérisé en ce que ledit isolant est un oxyde d'aluminium.

6. Laser selon la revendication 4, caractérisé en ce que ladite couche de blocage est une entaille obtenue par une gravure latérale dans ladite couche d'injection (SH).

## Patentansprüche

1. Oberflächenemissionslaser vom Typ, der umfasst: eine in eine Stromeinspeisungsschicht (SH) vergrabene aktive Schicht (CA), die sich aus einer p-dotierten III-V-Halbleiterlegierung zusammensetzt, wenigstens einen zur aktiven Schicht (CA) parallelen Spiegel (MH), der auf der Einspeisungsschicht (SH) angeordnet ist, und eine Elektrode (EH), die neben dem Spiegel (MH) plaziert ist und in elektrischem Kontakt mit der Einspeisungsschicht (SH) ist, **dadurch gekennzeichnet,** dass er eine Stromblockierungsschicht (B) umfasst, die in der Einspeisungsschicht (SH) in einer zur aktiven Schicht (CA) in etwa parallelen Ebene liegt, wobei die Blockierungsschicht (B) mit einer Öffnung versehen ist, die auf die aktive Schicht (CA) zentriert ist und kleinere Abmessungen als diese hat.

2. Laser nach Anspruch 1, dadurch gekennzeichnet, dass die Abmessungen der Öffnung (D) und der Abstand (h) zwischen der Blockierungsschicht (B) und der aktiven Schicht (CA) so gewählt sind, dass der elektrische Strom, der die aktive Schicht (CA) durchquert, eine gleichförmige Stromdichte (J) aufweist.

3. Laser nach einem der Ansprüche 1 oder 2, dadurch gekennzeichnet, dass die Blockierungsschicht (B) sich aus einer n-dotierten III-V-Halbleiterlegierung zusammensetzt.

4. Laser nach einem der Ansprüche 1 oder 2, dadurch gekennzeichnet, dass die Blockierungsschicht aus einem elektrischen Isolator besteht.

5. Laser nach Anspruch 4, dadurch gekennzeichnet, dass der Isolator Aluminiumoxid ist.

6. Laser nach Anspruch 4, dadurch gekennzeichnet, dass die Blockierungsschicht eine Einkerbung ist, die durch eine seitliche Ätzung in der Einspeisungsschicht (SH) erhalten wurde.

## Claims

1. A surface emitting laser of the type including an active layer (CA) buried in an electrical current injection layer (SH) made of a p-doped III-V semiconductor alloy, at least one mirror (MH) parallel to the active layer (CA) on the injection layer (SH), an electrode (EH) alongside said mirror (MH) and in electrical contact with the injection layer (SH), characterised in that it includes a current blocking layer (B) in the injection layer (SH) in a plane substantially parallel to the active layer (CA), said blocking layer (B) having an opening (D) centred relative to the active layer (CA) and having smaller dimensions than the latter.

2. A laser according to claim 1 characterised in that the dimensions of the opening (D) and the distance (h) between the blocking layer (B) and the active layer (CA) are chosen so that the electric current flowing through the active layer (CA) has a uniform current density (J).

3. A laser according to claim 1 or claim 2 characterised in that said blocking layer (B) is made of said n-doped III-V semiconductor alloy.

4. A laser according to claim 1 or claim 2 characterised in that said blocking layer is made from an electrical insulator.

5. A laser according to claim 4 characterised in that said insulator is aluminium oxide.

6. A laser according to claim 4 characterised in that said blocking layer is a notch obtained by lateral etching in said injection layer (SH).
